# FASCICULE DE BREVET EUROPEEN

(11) **EP 3 144 687 B1**
(45) Date de publication et mention de la délivrance du brevet: **01.09.2021**
(21) Numéro de dépôt: 16187978.8
(22) Date de dépôt: 09.09.2016
(51) Int. Cl.: G01R 31/26, G01R 1/067

(54) **DISPOSITIF DE CARACTERISATION D'UN COMMUTATEUR DE PUISSANCE**
VORRICHTUNG ZUR CHARAKTERISIERUNG EINES LEISTUNGSSCHALTERS
DEVICE FOR CHARACTERISING A POWER SWITCH

(30) Priorité: 16.09.2015 FR 1558711
(43) Date de publication de la demande: 22.03.2017
(73) Titulaire: Commissariat à l'énergie atomique et aux énergies alternatives, 75015 Paris (FR); Centre National de la Recherche Scientifique, 75016 Paris (FR)
(72) Inventeur: MARCAULT, Emmanuel, 31400 TOULOUSE (FR); TREMOUILLES, David, 82000 MONTAUBAN (FR)
(74) Mandataire: INNOV-GROUP

(56) Documents cités:
- US-A- 4 977 371
- US-A1- 2008 309 355
- US-A1- 2012 268 138
- US-A1- 2013 049 783
- US-A1- 2014 139 206
- US-A1- 2014 320 157
- G Gürkan: "Electronic Circuits I Laboratory - 2 DIODE CLIPPING and CLAMPING CIRCUITS", , 7 avril 2009 (2009-04-07), XP055286065, Extrait de l'Internet: URL:http://web.iku.edu.tr/courses/ee/ee425 /PDF/_EE%20425_Exp_2.pdf [extrait le 2016-07-05]

## Description

L'invention concerne la caractérisation de composants électroniques de puissance, et en particulier les dispositifs de mesure destinés à analyser la commutation de composants de puissance.

Un interrupteur ou commutateur de puissance doit fréquemment être caractérisé. La caractérisation doit couvrir non seulement la résistance de conduction statique, mais également le fonctionnement dynamique du commutateur de puissance, par exemple pour déterminer la réponse de sa résistance de conduction lors d'une commutation de l'état ouvert vers l'état fermé. Une méthode de caractérisation usuelle d'un commutateur de puissance est de connecter une sonde de tension aux bornes du commutateur et de connecter cette sonde de tension à un oscilloscope. A l'état ouvert, la tension maximale aux bornes du commutateur peut dépasser 1kV. La sonde de tension doit donc être dimensionnée pour une tension supérieure à cette tension maximale. A l'état fermé, la tension aux bornes du commutateur sera usuellement comprise entre quelques millivolts et plusieurs Volts et le commutateur pourra être traversé par des courants dépassant une centaine d'ampères. Une sonde dimensionnée pour les hautes tensions, associée à un calibre de l'oscilloscope permettant de visionner à la fois la haute tension à l'état ouvert et la basse tension à l'état fermé, aboutit à une très mauvaise résolution de mesure à basse tension. La basse tension est en effet numérisée avec très peu de niveaux différents, ce qui rend la mesure sensible au bruit à l'entrée de l'oscilloscope. Par exemple, la sonde commercialisée sous la référence Tektronix TPP0850 supporte une tension de 1kV mais ne présente qu'une résolution de 50mV par division en pleine échelle, ce qui s'avère incompatible avec la mesure basse tension.

Selon une variante de méthode de caractérisation, on choisit un calibre d'oscilloscope inférieur à la tension maximale, et plus adapté à la mesure à basse tension. La haute tension entraîne une saturation de l'entrée de l'oscilloscope. Le délai entre la commutation vers la basse tension à l'état fermé et la mesure correcte de cette commutation, peut alors atteindre plusieurs dizaines de microsecondes.

Le document US2013/0049783 A1 décrit un circuit d'écrêtage de tension, destiné à mesurer une tension au niveau d'un nœud, lors d'une commutation entre une haute tension et une basse tension.

Le circuit d'écrêtage de tension comprend un circuit miroir de courant et une alimentation continue connectée entre la masse et un nœud commun à deux bornes d'alimentation du circuit miroir de courant. Le circuit d'écrêtage de tension comporte également des première et deuxième bornes de sortie connectées à une borne d'entrée d'un oscilloscope par l'intermédiaire d'une mesure différentielle. Plusieurs diodes sont connectées en série dans une branche unidirectionnelle entre les première et deuxième bornes de sortie du circuit d'écrêtage, l'anode d'une diode étant connectée à la première sortie, la cathode d'une autre diode étant connectée à la deuxième sortie. Une première diode de puissance a son anode connectée à la première sortie du circuit d'écrêtage, et sa cathode connectée à une première borne d'entrée du circuit d'écrêtage. Une deuxième diode de puissance a son anode connectée à la deuxième sortie du circuit d'écrêtage, et sa cathode connectée à une deuxième borne d'entrée du circuit d'écrêtage. Cette deuxième borne d'entrée du circuit d'écrêtage est connectée à la masse. La première borne d'entrée du circuit d'écrêtage de tension est destinée à être connectée à un drain d'un transistor à effet de champ de puissance à caractériser. Le circuit miroir de courant produit un courant de référence sur la deuxième borne de sortie, ce courant traversant la deuxième diode de puissance. Lorsque le transistor à effet de champ de puissance à caractériser est fermé, un courant miroir est appliqué sur la première borne de sortie, ce courant traversant la première diode de puissance.

La branche unidirectionnelle nécessite plusieurs diodes connectées en série induisant un surcoût. De même, la nécessité d'un circuit miroir de courant et d'une sonde différentielle à l'entrée de l'oscilloscope peut induire un surcoût non négligeable. Par ailleurs, une mesure précise repose sur une très grande similitude entre les diodes de puissance et une très grande stabilité de l'alimentation continue.

Le document US2008/309355 A1 décrit un dispositif un dispositif de caractérisation d'un commutateur de puissance, avec:
- un nœud d'alimentation, destiné à être connecté à une première électrode de conduction du commutateur de puissance à caractériser ;
- un circuit d'alimentation comprenant :
   - une source de tension continue générant un deuxième potentiel d'alimentation ;
   - une première résistance connectée en série entre la deuxième source de tension continue et ledit nœud d'alimentation ;
   - un circuit d'écrêtage de tension comprenant :
      - une troisième source de tension continue ;
      - une deuxième résistance ;
         - une borne de mesure.

Le document « Electronic Circuits I Laboratory -2 Diode Clipping and clamping circuits », publié le 7 avril 2009, fournit un enseignement concernant des exemples de circuits d'écrêtage et de circuits de mesure à bases de montages de diodes et d'alimentations.

Le document US2012/268138 A1 décrit un dispositif de caractérisation d'un commutateur de puissance avec :
- un nœud d'alimentation destiné à être connecté à une première électrode de conduction du commutateur de puissance à caractériser ;
- un circuit d'alimentation comprenant :
   - une première source de tension continue générant un premier potentiel d'alimentation ;
   - une première diode connectée en série entre la première source de tension continue et ledit nœud d'alimentation;
- un circuit d'écrêtage de tension comprenant :
   - une troisième source de tension continue ;
   - une deuxième diode connectée en série entre la troisième source de tension continue et ledit nœud d'alimentation.

Aucune solution connue ne permet donc de caractériser un commutateur de puissance en un temps suffisamment court, avec suffisamment de précision en basse tension et à un coût suffisamment raisonnable.

L'invention vise à résoudre un ou plusieurs de ces inconvénients. L'invention porte ainsi sur un dispositif de caractérisation d'un commutateur de puissance, comprenant :
- un nœud d'alimentation, destiné à être connecté à une première électrode de conduction du commutateur de puissance à caractériser ;
- un circuit d'alimentation comprenant :
   - une première source de tension continue générant un premier potentiel d'alimentation ;
   - une première diode connectée en série entre la première source de tension continue et ledit nœud d'alimentation, connectée de façon à être traversée par un courant direct allant de la première source de tension vers ledit nœud d'alimentation ;
   - une deuxième source de tension continue générant un deuxième potentiel d'alimentation supérieur au premier potentiel d'alimentation ;
   - une première résistance connectée en série entre la deuxième source de tension continue et ledit nœud d'alimentation ;
- un circuit d'écrêtage de tension comprenant :
   - une troisième source de tension continue ;
   - une deuxième résistance et une deuxième diode connectées en série entre la troisième source de tension continue et ledit nœud d'alimentation, la deuxième diode étant connectée de façon à être traversée par un courant direct allant de la troisième source de tension vers ledit nœud d'alimentation ;
   - une borne de mesure, connectée à un nœud intermédiaire entre la deuxième résistance et la deuxième diode.

L'invention porte également sur les variantes suivantes. L'homme du métier comprendra que chacune des caractéristiques des variantes suivantes peut être combinée indépendamment aux caractéristiques ci-dessus, sans pour autant constituer une généralisation intermédiaire.

Selon une variante, ledit circuit d'écrêtage de tension comprend :
- une troisième résistance et une troisième diode connectée en série entre la troisième source de tension continue et ledit nœud d'alimentation;
- une borne de mesure additionnelle, connectée à un nœud intermédiaire entre la troisième résistance et la troisième diode.

Selon encore une variante, ledit circuit d'écrêtage de tension comprend des quatrième et cinquième diodes, lesdites quatrième et cinquième diodes et ladite deuxième résistance étant connectées en parallèle, l'anode de la quatrième diode étant connectée à la cathode de la cinquième diode.

Selon une autre variante, le dispositif comprend en outre un circuit RLC connecté entre ladite première résistance et ledit nœud d'alimentation.

Selon encore une autre variante, le dispositif comprend un condensateur de découplage connecté en parallèle de ladite première source de tension continue.

Selon une variante, le dispositif comprend un condensateur de découplage connecté en parallèle de ladite deuxième source de tension continue.

Selon encore une variante, ladite première diode présente une tension de claquage au moins égale à 100 V, un courant direct continu au moins égal à 1A et un temps de recouvrement direct au plus égal à 1 µs.

Selon encore une autre variante, la première source de tension continue est configurée pour délivrer un courant au moins égal à 1 A.

Selon une autre variante, la première source de tension continue est configurée pour générer un premier potentiel d'alimentation au plus égal à 20 V.

Selon encore une autre variante, la deuxième source de tension continue est configurée pour générer un potentiel d'alimentation au moins égal à 100 V.

L'invention porte également sur un système, comprenant
- un dispositif de caractérisation tel que défini ci-dessus ;
- un commutateur de puissance présentant une électrode de commande, une première électrode de conduction connectée au nœud d'alimentation, une deuxième électrode de conduction par rapport au potentiel de laquelle lesdits potentiels d'alimentation des premier à troisième sources d'alimentation continue sont générés ;
- un circuit de commande configuré pour appliquer séquentiellement un signal d'ouverture et un signal de fermeture sur l'électrode de commande du commutateur de puissance.

Selon une variante, le système comprend en outre un dispositif d'acquisition connecté à ladite borne de mesure.

Selon une autre variante, le dispositif d'acquisition comprend un circuit de conversion de la tension appliquée sur la borne de mesure en une valeur de tension présente sur la première électrode de conduction dudit commutateur de puissance, le circuit de conversion étant configuré pour mesurer une première tension sur la borne de mesure lorsque le commutateur de puissance est stabilisé à l'état fermé, configuré pour mesurer une deuxième tension sur la borne de mesure lorsque le commutateur de puissance est ouvert et que la deuxième source de tension continue applique une tension prédéterminée, le circuit de conversion étant en outre configuré pour extrapoler une loi de conversion affine en fonction des première et deuxième tensions mesurées et en fonction de ladite tension prédéterminée.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un exemple de système incluant un circuit d'écrêtage de tension et une alimentation selon un exemple de mode de réalisation de l'invention ;
- la figure 2 est une représentation schématique d'une première variante d'alimentation de caractérisation ;
- la figure 3 est une représentation schématique d'une deuxième variante d'alimentation de caractérisation ;
- la figure 4 est une représentation schématique d'une troisième variante d'alimentation de caractérisation ;
- la figure 5 est une représentation schématique d'une première variante de circuit d'écrêtage selon l'invention ;
- la figure 6 est une représentation schématique d'une deuxième variante de circuit d'écrêtage selon l'invention ;
- la figure 7 est une représentation schématique d'une troisième variante de circuit d'écrêtage selon l'invention ;
- la figure 8 est un diagramme comparant une mesure effectuée par un dispositif de caractérisation selon l'invention par rapport à une mesure effectuée avec un dispositif de caractérisation selon l'état de la technique.

L'invention propose un dispositif de caractérisation d'un commutateur de puissance. Ce dispositif comprend notamment une alimentation comportant une source de tension destinée à fournir une haute tension sur une électrode de conduction du commutateur à caractériser pour l'état ouvert de ce commutateur, et une autre source de tension destinée à fournir un courant élevé dès la fermeture du commutateur. Le dispositif de caractérisation comprend par ailleurs un circuit d'écrêtage de tension utilisant une source de tension continue additionnelle, avec une borne de mesure connectée à un nœud intermédiaire entre une résistance et une diode, la résistance et la diode étant connectées en série sur une sortie de cette source de tension continue additionnelle.

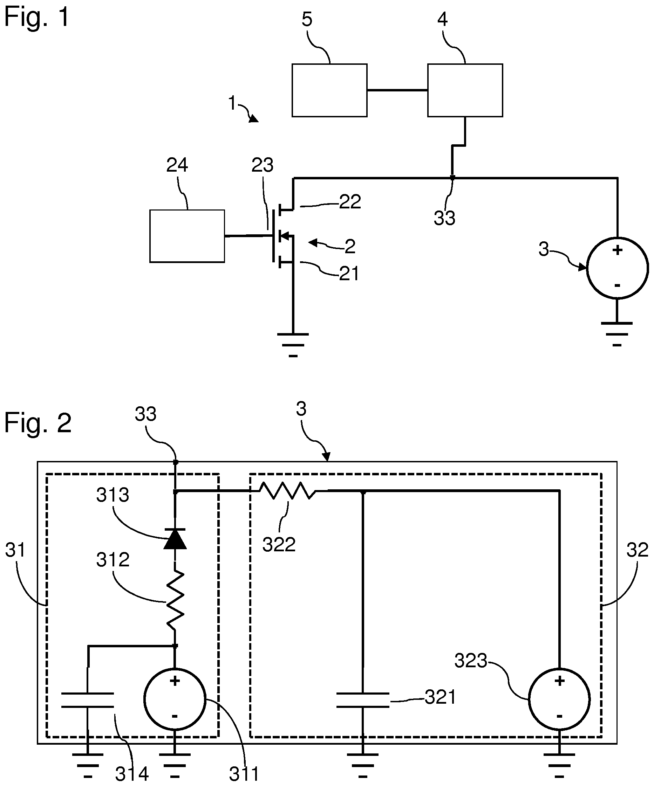

La figure 1 illustre de façon schématique un commutateur de puissance 2 connecté à un dispositif de caractérisation 1. Le commutateur de puissance 2 comporte une première électrode de conduction 21, une deuxième électrode de conduction 22, et une électrode de commande 23. La première électrode de conduction 21 est connectée à la masse. Un circuit de commande 24 est connecté à l'électrode de commande 23 pour commander séquentiellement des ouvertures et des fermetures du commutateur 2. Dans l'exemple illustré, le commutateur 2 est un transistor à effet de champ de type MOS présentant une source 21, un drain 22 et une grille 23.

Le dispositif de caractérisation 1 comporte un circuit d'alimentation 3 connecté à un nœud d'alimentation 33 connecté au drain 22. Le dispositif de caractérisation 1 comprend également un circuit d'écrêtage de tension 4 dont une entrée est connectée au nœud d'alimentation 33 et dont une sortie est ici connectée à un dispositif d'acquisition 5.

La figure 2 illustre une première variante d'un circuit d'alimentation 3 pour la mise en œuvre de l'invention. Le circuit d'alimentation 3 comporte un circuit 32 destiné à appliquer une haute tension sur le nœud d'alimentation 33, le niveau de cette haute tension servant à caractériser le commutateur 2 dans son état ouvert. Le circuit d'alimentation 3 comporte un circuit 31 destiné à appliquer un fort courant à travers le commutateur 2 dans son état fermé par l'intermédiaire du nœud d'alimentation 33.

Le circuit 31 comporte une source de tension continue 311 générant un premier potentiel d'alimentation par rapport à une tension de masse. La source de tension continue 311 est configurée pour pouvoir débiter un fort courant, typiquement au moins égal à 1 A, de préférence au moins égal à 5 A, et avantageusement au moins égal à 10 A.

Une diode 313 est connectée en série entre la source de tension 311 et le nœud d'alimentation 33. La diode 313 est connectée de façon à être traversée par un courant direct allant de la source de tension 311 vers le nœud d'alimentation 33. La cathode de la diode 313 est ainsi connectée au nœud d'alimentation 33 dans l'exemple illustré.

Une résistance 312 est ici avantageusement connectée en série avec la diode 313 entre la source de tension 311 et le nœud d'alimentation 33. Le circuit 31 comporte ici avantageusement un condensateur de découplage 314 connecté en parallèle de la source de tension continue 311. Les différents condensateurs de découplage détaillés par la suite visent à stabiliser les alimentations dans une large gamme de fréquences et ainsi limiter au maximum les oscillations des circuits, afin de gagner en rapidité. Grâce aux différents condensateurs de découplage détaillés dans les différentes variantes, la stabilité des tensions du circuit correspondant sont parfaitement maîtrisées.

Le circuit 32 comporte une source de tension continue 323 générant un deuxième potentiel d'alimentation par rapport à la tension de masse. Le deuxième potentiel d'alimentation est supérieur au premier potentiel d'alimentation. Le deuxième potentiel d'alimentation présente une amplitude pour laquelle le commutateur 2 doit être caractérisé. Le deuxième potentiel d'alimentation est par exemple au moins égal à 100 V, de préférence au moins égal à 500 V, et avantageusement au moins égal à 1000 V, en fonction du commutateur de puissance devant être caractérisé. La diode 313 du circuit 31 est dimensionnée pour présenter une tension de claquage au moins égale au deuxième potentiel d'alimentation appliqué sur le nœud d'alimentation 33 lorsque le commutateur 2 est ouvert.

Le circuit 32 comporte une résistance 322 connectée en série entre la source de tension continue 323 et le nœud d'alimentation 33. La résistance 322 permet de protéger la source de tension 323 du courant débité par la source de tension 311. La résistance 322 permet également de créer une chute de tension entre la source de tension 323 et le nœud d'alimentation 33 lorsque le commutateur 2 est fermé, et permet de stabiliser la source de tension 323.

Le circuit 32 comporte ici avantageusement un condensateur de découplage 321 connecté en parallèle de la source de tension continue 323.

Le circuit 32 peut également inclure une alimentation pilotable, par exemple pour appliquer des impulsions de tension.

Lorsque le commutateur 2 est ouvert, le courant traversant la résistance 322 est sensiblement nul et le deuxième potentiel généré par la source de tension 323 est appliqué sur le nœud d'alimentation 33 et sur l'électrode de conduction 22. Comme le deuxième potentiel d'alimentation est supérieur au premier potentiel d'alimentation (généré par la source de tension 311), le potentiel sur le nœud d'alimentation 33 est supérieur au potentiel généré par la source de tension 311. La diode 313 est alors bloquée et la source de tension 311 fournit alors un courant nul.

Lorsque le commutateur 2 commute vers l'état fermé, le potentiel de l'électrode de conduction 22 chute fortement et tire le potentiel du nœud d'alimentation 33 jusqu'à rendre la diode 313 conductrice. La diode 313 est alors très rapidement traversée par le courant débité par la source de tension 311.

Pour permettre une application très rapide du fort courant débité par la source de tension 311 sur le commutateur 2 fermé, la diode 313 présente avantageusement un temps de recouvrement direct au plus égal à 1µs, de préférence au plus égal à 500 ns et avantageusement au plus de 200 ns, et préférentiellement au plus de 100ns. Une diode SiC commercialisée sous la référence C4D05120E par la société CREE présente notamment un temps de recouvrement direct nul, une capacité totale de charge (Qc) de 27 nC, une tension de claquage de 1200V et un courant direct continu de 9A.La source de tension 311 peut être configurée pour débiter un courant plus ou moins élevé à travers le commutateur 2 fermé, en fonction du courant auquel ce commutateur 2 doit être caractérisé.

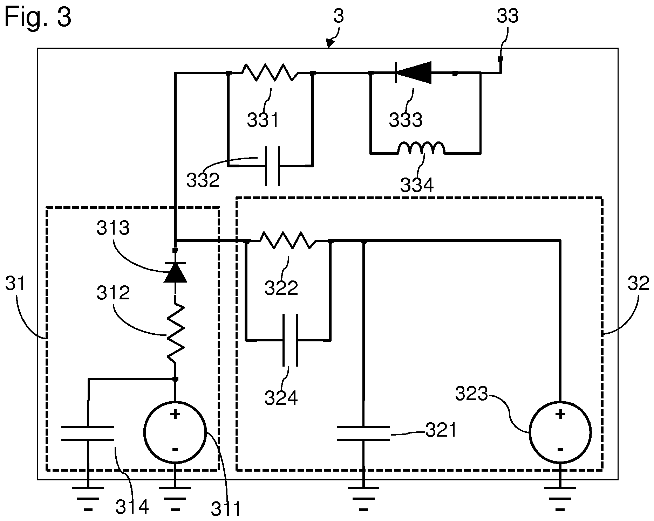

La figure 3 illustre une deuxième variante d'un circuit d'alimentation 3 pour la mise en oeuvre de l'invention. Le circuit 31 est ici identique à celui détaillé en référence à la figure 2. Le circuit 32 diffère du circuit 32 de la figure 2 uniquement par la présence d'un condensateur 324 connecté en parallèle de la résistance 322.

Indépendamment de la structure des circuits 31 et 32, cette variante comporte un circuit de charge configurable à partir de composants RLC connectés entre le nœud d'alimentation 33 et un nœud commun à la résistance 322 et à la cathode de la diode 313. La présence d'un tel circuit RLC permet de caractériser le comportement du commutateur 2 en présence de charges électriques de différents types.

Dans la présente variante, le circuit RLC comprend deux modules connectés en série. Le premier module comprend une résistance 331 et un condensateur 332 connectés en parallèle. Le deuxième module comprend une inductance 334 et une diode 333. La diode 333 est connectée au nœud d'alimentation 33 par son anode, et sa cathode est connectée au premier module.

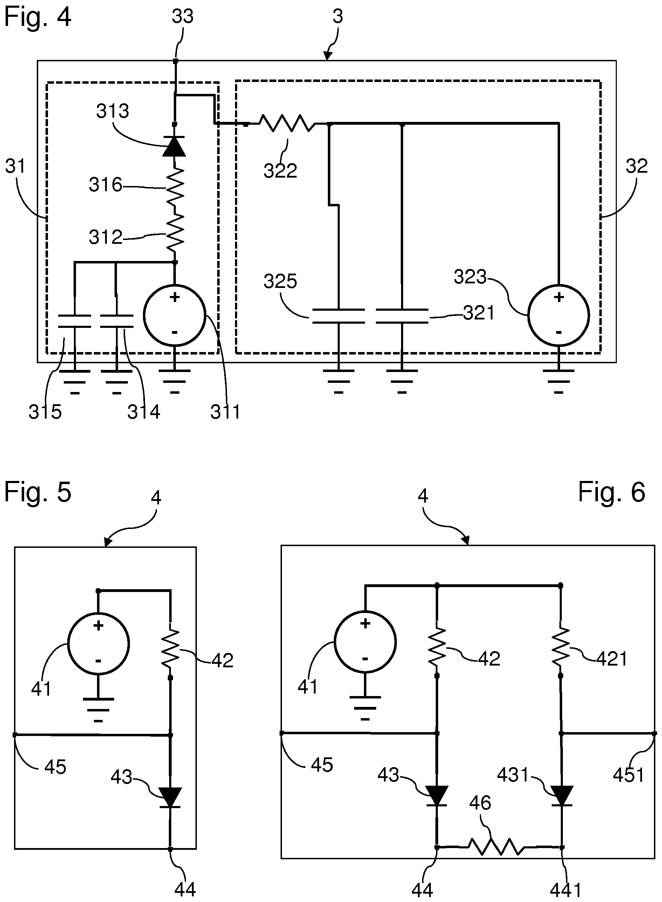

La figure 4 illustre une troisième variante d'un circuit d'alimentation 3 pour la mise en œuvre de l'invention qui permet de stabiliser les alimentations sur un plus large spectre de fréquences. Le circuit 31 diffère du circuit 31 de la figure 2
- par la présence d'un condensateur de découplage 315 en parallèle de la source de tension 311 et du condensateur 314 ;
- par la présence d'une résistance 316 (en vue de dissiper plus facilement la chaleur) connectée en série avec la diode 313 et la résistance 312.

Le circuit 32 diffère du circuit 32 de la figure 2 par la présence d'un condensateur de découplage 325 en parallèle de la source de tension 323 et du condensateur 321.

Le condensateur 314 peut être un condensateur céramique multicouches commercialisé sous la référence VJ1812Y104KXET par la société Vishay, d'une capacité de 100nF, pour une tension de 500V en courant continu. Le condensateur 315 peut-être un condensateur céramique multicouches commercialisé par la société Murata sous la référence GRM188R72A104KA35D, d'une capacité de 100 µF, pour une tension de 100 V en courant continu. Les condensateurs 321 et 325 pourront être des condensateurs en boîtier au format 1812, tels que des condensateurs commercialisés respectivement sous les références Syfer 1812J2K00102KXT (1 nF, 2 kV, diélectrique X7R, CMS) et Syfer 1812Y1 K00473KXT (47nF, 1kV)

. La diode 313 peut par exemple être une diode commercialisée par la société Vishay sous la référence VS-8ETH06SPbF, présentant une tension de claquage de 600 V, un courant direct continu de 8 A, et un temps de recouvrement direct de 25 ns. La diode 313 peut également être une diode commercialisée par la société Vishay sous la référence HFA06TB120SPbF, présentant une tension de claquage de 1200 V, un courant direct continu de 8 A, et un temps de recouvrement direct de 80 ns, ou encore une diode SiC commercialisée sous la référence C4D05120E par la société CREE (présentant notamment un temps de recouvrement direct nul, une capacité totale de charge (Qc) de 27 nC, une tension de claquage de 1200V et un courant direct continu de 9A).

Des résistances de puissance 312 et 316 commercialisées par la société Bourns sous la référence RWS10 1R J, par exemple avec chacune une valeur de résistance de 1 Ω. Une résistance de puissance 322 commercialisée par la société Bourns sous la référence PWR263S-20 peut être utilisée, par exemple avec une valeur de résistance de 100k Ω pour un exemple de VHT de 800V.

La figure 5 illustre une première variante d'un circuit d'écrêtage 4 pour la mise en oeuvre de l'invention. Le circuit d'écrêtage 4 comporte une source de tension continue 41 générant un troisième potentiel d'alimentation par rapport à une tension de masse. Le troisième potentiel présente typiquement un potentiel inférieur ou égal à 10 V. Le circuit d'écrêtage 4 comprend en outre une résistance 42 et une diode 43 connectées en série entre la source de tension 41 et une borne d'entrée 44. La borne d'entrée 44 est en pratique connectée au nœud d'alimentation 33. La diode 43 est connectée de façon à être traversée par un courant direct allant de la source de tension 41 vers la borne d'entrée 44. Une borne de mesure 45 est connectée à un nœud intermédiaire entre la résistance 42 et la diode 43. La borne de mesure 45 est ainsi connectée à l'anode de la diode 43.

Le circuit d'écrêtage 4 permet de s'affranchir d'un éventuel problème de saturation d'un oscilloscope ou d'un dispositif d'acquisition 5 connecté à la borne de mesure 45, ce qui permet d'augmenter sensiblement la résolution de mesure tout en restant compatible avec le niveau de tension appliqué sur l'électrode de conduction 22 lorsque le commutateur est ouvert. La mesure de la tension de l'électrode de conduction 22 est effectuée derrière la diode 43. Lorsque la tension aux bornes du commutateur 2 à caractériser est supérieure au troisième potentiel d'alimentation, la diode 43 est polarisée en inverse et le courant la traversant est extrêmement faible. La tension sur la borne de mesure 45 ne peut pas dépasser le troisième potentiel d'alimentation.

Lorsque la tension aux bornes du commutateur 2 (additionnée à la tension de seuil de la diode 43) devient inférieure au troisième potentiel d'alimentation, la diode 43 est polarisée en direct et se comporte sensiblement comme un interrupteur fermé. La tension appliquée sur la borne de mesure 45 correspond à la tension de seuil moins la chute de tension provoquée par la diode 43. La plage de tension du commutateur 2 fermé peut être ajustable avec la tension de polarisation de la diode 43.

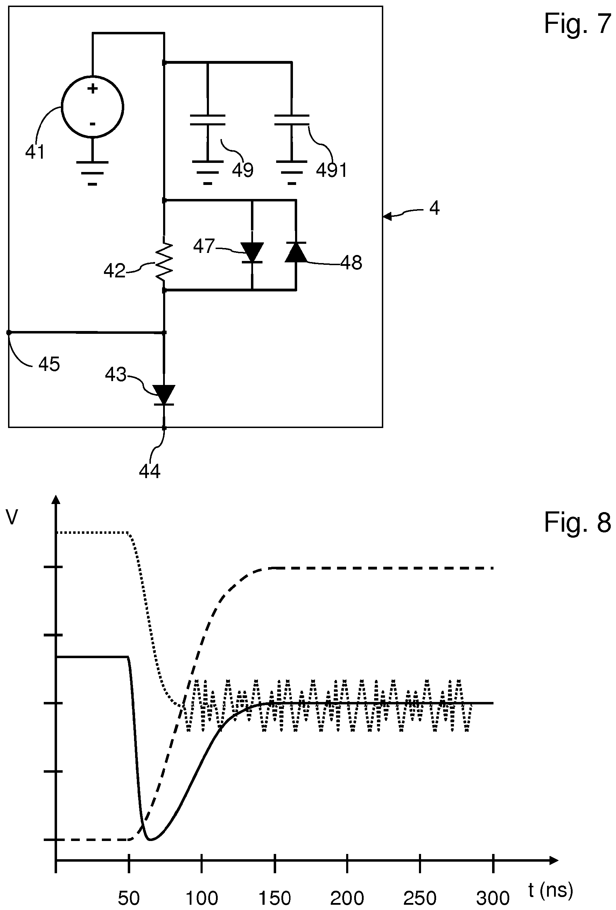

Par des mesures telles qu'illustrées à la figure 8, on a pu constater qu'un dispositif de caractérisation 1 selon l'invention pouvait présenter une résolution de mesure 100 fois supérieure à celle obtenue avec une sonde de tension selon l'état de la technique. Le diagramme de la figure 8 illustre en trait discontinu une tension appliquée sur la grille d'un transistor à effet de champ utilisé comme commutateur de puissance 2 (échelle de tension différente), en trait continu la tension sur la borne de mesure 45 du circuit d'écrêtage 4, et en pointillé la tension sur une borne de mesure d'une sonde de tension selon l'état de la technique. On constate que la mesure correcte de tension sur la borne de mesure 45 n'est retardée que de 100ns par rapport au signal de commutation appliqué sur la grille du transistor.

A partir de la tension appliquée sur la borne de sortie 45, le dispositif d'acquisition 5 peut réaliser une conversion de cette tension en la valeur de tension présente sur l'électrode de conduction 22. Cette conversion peut être réalisée au moyen d'un circuit de conversion du dispositif d'acquisition 5. Le dispositif de conversion peut être étalonné sur la base de mesures préalables.

Par exemple, l'étalonnage peut être réalisé de la façon suivante. On maintient le commutateur 2 à l'état fermé et on mesure la tension sur la borne de mesure 45 dans cette configuration, afin de définir une valeur de décalage. Ensuite, on maintient le commutateur 2 à l'état ouvert, en appliquant un deuxième potentiel d'alimentation d'un niveau prédéterminé. Une loi de conversion affine peut alors être déterminée en fonction de ces mesures de tension. On peut alors programmer le circuit de conversion pour utiliser cette loi de conversion affine, fournissant la tension sur l'électrode de conduction 22 en fonction de la tension sur la borne de sortie 45.

La figure 6 illustre une deuxième variante de circuit d'écrêtage 4 pour la mise en œuvre de l'invention. Le circuit d'écrêtage 4 reprend la source de tension continue 41, la résistance 42, la diode 43, la borne d'entrée 44 et la borne de mesure 45 de la variante de la figure 5. Le circuit d'écrêtage 4 comprend ici en outre une résistance 421 et une diode 431 connectées en série entre un nœud de sortie de la source de tension 41 et une autre borne d'entrée 441. Les bornes d'entrée 44 et 441 sont reliées par une résistance 46. Un nœud intermédiaire entre la résistance 421 et la diode 431 est connecté à une autre borne de mesure 451. L'anode de la diode 431 est connectée à la borne de mesure 451 et la cathode de la diode 431 est connectée à la borne d'entrée 441.

La figure 7 illustre une troisième variante de circuit d'écrêtage 4 pour la mise en œuvre de l'invention. Le circuit d'écrêtage 4 reprend la source de tension continue 41, la résistance 42, la diode 43, la borne d'entrée 44 et la borne de mesure 45 de la variante de la figure 5.

Des diodes 47 et 48 sont connectées chacune en parallèle de la résistance 42. L'anode de la diode 48 est connectée à la cathode de la diode 47 et la cathode 48 est connectée à l'anode de la diode 47. Les diodes 47 et 48 permettent de limiter le pic de tension illustré à la figure 8 lors de la commutation du commutateur 2, qui peut être induit par une capacité relativement importante de la diode 43. Les diodes 47 et 48 sont par exemple choisies pour présenter un temps de recouvrement direct très réduit.

Le circuit d'écrêtage 4 comporte par ailleurs des condensateurs de découplage 49 et 491 connectés chacun en parallèle de la source de tension continue 41.

Le condensateur 49 peut être un condensateur céramique multicouches commercialisé sous la référence VJ1812Y104KXET par la société Vishay, d'une capacité de 100nF, pour une tension de 500V en courant continu. Le condensateur 491 peut-être un condensateur céramique multicouches commercialisé par la société Murata sous la référence GRM188R72A104KA35D, d'une capacité de 100 µF, pour une tension de 100 V en courant continu. La diode 43 peut par exemple être une diode commercialisée par la société Vishay sous la référence VS-8ETH06SPbF, présentant une tension de claquage de 600V, un courant direct continu de 8 A, et un temps de recouvrement direct de 25 ns. La diode 43 peut également être une diode commercialisée par la société Vishay sous la référence HFA06TB120SPbF, présentant une tension de claquage de 1200 V, un courant direct continu de 8 A, et un temps de recouvrement direct de 80 ns. Une diode 43 commercialisée sous la référence STTH812 par la société STMicroelectronics peut également être utilisée, et présente notamment un temps de recouvrement direct 250 ns, une tension de claquage de 1200 V et un courant direct continu de 8 A. Une résistance 42 de type CMS, commercialisée par la société Panasonic sous la référence ERA6ARW102V peut être utilisée, par exemple avec une valeur de résistance de 1kΩ. Les diodes 47 et 48 peuvent par exemple être des diodes commercialisées par la société Vishay sous la référence GSD2004W.

En alternative aux différentes diodes mentionnées précédemment, basées sur une structure silicium, il est possible d'utiliser une ou plusieurs diodes de type SiC qui présentent un temps de recouvrement direct quasiment nul. La diode commercialisée par la société STMicroelectronics sous la référence STTH512B-TR, ou la diode commercialisée par la société Semisouth sous la référence SDP30S120 s'avèrent par exemple appropriées.

La connectique de la source de tension 311 peut par exemple être de type BNC pour un bord de plaque. La connectique pour la source de tension 41 et pour la borne de mesure 45 est par exemple de type BNC. La connectique pour la source de tension 323 et pour l'électrode de conduction 22 peut par exemple être de type SHV.

Les composants du dispositif de caractérisation 1 sont avantageusement fixés sur un substrat d'une épaisseur de 1,2mm de type FR-4, muni d'un plan de masse. Les pistes conductrices pourront par exemple présenter une largeur de 1,7 mm, avec un espacement de 600 µm. L'épaisseur des pistes pourra par exemple être de 35 µm. Le substrat pourra par exemple être un diélectrique d'une épaisseur de 1,2 mm avec une permittivité relative de 4,6.

Le commutateur de puissance 2 à caractériser est avantageusement brasé sur un circuit imprimé adapté en impédance. Il est ainsi possible de conserver une bande passante maximale pour une mesure optimale en maîtrisant les oscillations du circuit formé.

Avantageusement, le circuit de commande 24 applique la tension de grille sur une entrée du dispositif d'acquisition 5. Le dispositif d'acquisition 5 peut ainsi effectuer une mesure temporelle de la tension de grille afin de garantir la stabilité des mesures.

## Revendications

1. Dispositif de caractérisation (1) d'un commutateur de puissance (2), comprenant :
- un nœud d'alimentation (33), destiné à être connecté à une première électrode de conduction du commutateur de puissance à caractériser ;
- un circuit d'alimentation (3) ; le circuit d'alimentation (3) comprenant :
- une première source de tension continue (311) générant un premier potentiel d'alimentation ;
- une première diode (313) connectée en série entre la première source de tension continue et ledit nœud d'alimentation, connectée de façon à être traversée par un courant direct allant de la première source de tension vers ledit nœud d'alimentation ;
- une deuxième source de tension continue (323) générant un deuxième potentiel d'alimentation supérieur au premier potentiel d'alimentation ;
- une première résistance (322) connectée en série entre la deuxième source de tension continue et ledit nœud d'alimentation (33) ;
- un circuit d'écrêtage de tension (4) comprenant :
- une troisième source de tension continue (41) ;
- une deuxième résistance (42) et une deuxième diode (43) connectées en série entre la troisième source de tension continue et ledit nœud d'alimentation, la deuxième diode étant connectée de façon à être traversée par un courant direct allant de la troisième source de tension vers ledit nœud d'alimentation ;
- une borne de mesure (45), connectée à un nœud intermédiaire entre la deuxième résistance et la deuxième diode.

2. Dispositif de caractérisation (1) selon la revendication 1, dans lequel ledit circuit d'écrêtage de tension (4) comprend :
- une troisième résistance (421) et une troisième diode (431) connectée en série entre la troisième source de tension continue (41) et ledit nœud d'alimentation (33) ;
- une borne de mesure additionnelle (451), connectée à un nœud intermédiaire entre la troisième résistance et la troisième diode.

3. Dispositif de caractérisation (1) selon la revendication 1 ou 2, dans lequel ledit circuit d'écrêtage (4) de tension comprend des quatrième et cinquième diodes (47,48), lesdites quatrième et cinquième diodes et ladite deuxième résistance (42) étant connectées en parallèle, l'anode de la quatrième diode étant connectée à la cathode de la cinquième diode.

4. Dispositif de caractérisation (1) selon l'une quelconque des revendications précédentes, comprenant en outre un circuit RLC (331,332,333,334) connecté entre ladite première résistance (322) et ledit nœud d'alimentation (33).

5. Dispositif de caractérisation (1) selon l'une quelconque des revendications précédentes, comprenant un condensateur de découplage (314) connecté en parallèle de ladite première source de tension continue (311).

6. Dispositif de caractérisation (1) selon l'une quelconque des revendications précédentes, comprenant un condensateur de découplage (321) connecté en parallèle de ladite deuxième source de tension continue (323).

7. Dispositif de caractérisation (1) selon l'une quelconque des revendications précédentes, dans lequel ladite première diode (313) présente une tension de claquage au moins égale à 100 V, un courant direct continu au moins égal à 1A et un temps de recouvrement direct au plus égal à 1µs.

8. Dispositif de caractérisation (1) selon l'une quelconque des revendications précédentes, dans lequel la première source de tension continue (311) est configurée pour délivrer un courant au moins égal à 1 A.

9. Dispositif de caractérisation (1) selon la revendication 8, dans lequel la première source de tension continue (311) est configurée pour générer un premier potentiel d'alimentation au plus égal à 20 V.

10. Dispositif de caractérisation (1) selon l'une quelconque des revendications précédentes, dans lequel la deuxième source de tension continue (323) est configurée pour générer un potentiel d'alimentation au moins égal à 100 V.

11. Système comprenant :
- un dispositif de caractérisation (1) selon l'une quelconque des revendications précédentes ;
- un commutateur de puissance (2) présentant une électrode de commande, une première électrode de conduction (22) connectée au nœud d'alimentation (33), une deuxième électrode de conduction (21) par rapport au potentiel de laquelle lesdits potentiels d'alimentation des premier à troisième sources d'alimentation continue sont générés ;
- un circuit de commande (24) configuré pour appliquer séquentiellement un signal d'ouverture et un signal de fermeture sur l'électrode de commande (23) du commutateur de puissance.

12. Système selon la revendication 11, comprenant en outre un dispositif d'acquisition (5) connecté à ladite borne de mesure.

13. Système selon la revendication 12, dans lequel le dispositif d'acquisition (5) comprend un circuit de conversion de la tension appliquée sur la borne de mesure (45) en une valeur de tension présente sur la première électrode de conduction (22) dudit commutateur de puissance, le circuit de conversion étant configuré pour mesurer une première tension sur la borne de mesure lorsque le commutateur de puissance est stabilisé à l'état fermé, configuré pour mesurer une deuxième tension sur la borne de mesure lorsque le commutateur de puissance est ouvert et que la deuxième source de tension continue applique une tension prédéterminée, le circuit de conversion étant en outre configuré pour extrapoler une loi de conversion affine en fonction des première et deuxième tensions mesurées et en fonction de ladite tension prédéterminée.

## Patentansprüche

1. Vorrichtung zur Charakterisierung (1) eines Leistungsschalters (2), die Folgendes beinhaltet:
- einen Versorgungsknoten (33), der dazu bestimmt ist, mit einer ersten Leitungselektrode des zu charakterisierenden Leistungsschalters verbunden zu sein;
- eine Versorgungsschaltung (3);
wobei die Versorgungsschaltung (3) Folgendes beinhaltet:
- eine erste Gleichspannungsquelle (311), die ein erstes Versorgungspotential erzeugt;
- eine erste Diode (313), die zwischen der ersten Gleichspannungsquelle und dem Versorgungsknoten in Reihe geschaltet ist und so verbunden ist, dass sie von einem Vorwärtsstrom, der von der ersten Spannungsquelle zu dem Versorgungsknoten fließt, durchquert wird;
- eine zweite Gleichspannungsquelle (323), die ein zweites Versorgungspotential, das größer als das erste Versorgungspotential ist, erzeugt;
- einen ersten Widerstand (322), der zwischen der zweiten Gleichspannungsquelle und dem Versorgungsknoten (33) in Reihe geschaltet ist;
- eine Spannungsbegrenzungsschaltung (4), die Folgendes beinhaltet:
- eine dritte Gleichspannungsquelle (41);
- einen zweiten Widerstand (42) und eine zweite Diode (43), die zwischen der dritten Gleichspannungsquelle und dem Versorgungsknoten in Reihe geschaltet sind, wobei die zweite Diode so verbunden ist, dass sie von einem Vorwärtsstrom, der von der dritten Spannungsquelle zu dem Versorgungsknoten fließt, durchquert wird;
- einen Messanschluss (45), der zwischen dem zweiten Widerstand und der zweiten Diode mit einem Zwischenknoten verbunden ist.

2. Charakterisierungsvorrichtung (1) nach Anspruch 1, wobei die Spannungsbegrenzungsschaltung (4) Folgendes beinhaltet:
- einen dritten Widerstand (421) und eine dritte Diode (431), die zwischen der dritten Gleichspannungsquelle (41) und dem Versorgungsknoten (33) in Reihe geschaltet sind;
- einen zusätzlichen Messanschluss (451), der zwischen dem dritten Widerstand und der dritten Diode mit einem Zwischenknoten verbunden ist.

3. Charakterisierungsvorrichtung (1) nach Anspruch 1 oder 2, wobei die Spannungsbegrenzungsschaltung (4) eine vierte und eine fünfte Diode (47, 48) beinhaltet, wobei die vierte und die fünfte Diode und der zweite Widerstand (42) parallel geschaltet sind, wobei die Anode der vierten Diode mit der Kathode der fünften Diode verbunden ist.

4. Charakterisierungsvorrichtung (1) nach einem der vorhergehenden Ansprüche, die ferner eine RLC-Schaltung (331, 332, 333, 334) beinhaltet, die zwischen dem ersten Widerstand (322) und dem Versorgungsknoten (33) verbunden ist.

5. Charakterisierungsvorrichtung (1) nach einem der vorhergehenden Ansprüche, die einen Entkopplungskondensator (314) beinhaltet, der zu der ersten Gleichspannungsquelle (311) parallel geschaltet ist.

6. Charakterisierungsvorrichtung (1) nach einem der vorhergehenden Ansprüche, die einen Entkopplungskondensator (321) beinhaltet, der zu der zweiten Gleichspannungsquelle (323) parallel geschaltet ist.

7. Charakterisierungsvorrichtung (1) nach einem der vorhergehenden Ansprüche, wobei die erste Diode (313) eine Durchbruchspannung von mindestens gleich 100 V, einen Vorwärtsgleichstrom von mindestens gleich 1 A und eine Vorwärtserholungszeit von höchstens gleich 1 µs aufweist.

8. Charakterisierungsvorrichtung (1) nach einem der vorhergehenden Ansprüche, wobei die erste Gleichspannungsquelle (311) dazu konfiguriert ist, einen Strom von mindestens gleich 1 A zu liefern.

9. Charakterisierungsvorrichtung (1) nach Anspruch 8, wobei die erste Gleichspannungsquelle (311) dazu konfiguriert ist, ein erstes Versorgungspotential von höchstens gleich 20 V zu erzeugen.

10. Charakterisierungsvorrichtung (1) nach einem der vorhergehenden Ansprüche, wobei die zweite Gleichspannungsquelle (323) dazu konfiguriert ist, ein Versorgungspotential von mindestens gleich 100 V zu erzeugen.

11. System, das Folgendes beinhaltet:
- eine Charakterisierungsvorrichtung (1) nach einem der vorhergehenden Ansprüche;
- einen Leistungsschalter (2), der Folgendes aufweist: eine Steuerelektrode, eine erste Leitungselektrode (22), die mit dem Versorgungsknoten (33) verbunden ist, eine zweite Leitungselektrode (21), in Bezug auf deren Potential die Versorgungspotentiale der ersten bis dritten kontinuierlichen Versorgungsquelle erzeugt werden;
- eine Steuerschaltung (24), die dazu konfiguriert ist, sequentiell ein Öffnungssignal und ein Schließsignal an die Steuerelektrode (23) des Leistungsschalters anzulegen.

12. System nach Anspruch 11, das ferner eine mit dem Messanschluss verbundene Erfassungsvorrichtung (5) beinhaltet.

13. System nach Anspruch 12, wobei die Erfassungsvorrichtung (5) eine Schaltung zur Umwandlung der an den Messanschluss (45) angelegten Spannung in einen Spannungswert, der an der ersten Leitungselektrode (22) des Leistungsschalters vorliegt, beinhaltet, wobei die Umwandlungsschaltung dazu konfiguriert ist, eine erste Spannung an dem Messanschluss zu messen, wenn der Leistungsschalter im geschlossenen Zustand stabilisiert ist, und dazu konfiguriert ist, eine zweiten Spannung an dem Messanschluss zu messen, wenn der Leistungsschalter geöffnet ist und die zweite Gleichspannungsquelle eine vorgegebene Spannung anlegt, wobei die Umwandlungsschaltung ferner dazu konfiguriert ist, ein Gesetz über die affine Umwandlung in Abhängigkeit von der ersten und zweiten gemessenen Spannung und in Abhängigkeit von der vorgegebenen Spannung zu extrapolieren.

## Claims

1. Characterization device (1) for characterizing a power switch (2), comprising:
- a power supply node (33), intended to be connected to a first conduction electrode of the power switch to be characterized;
- a power supply circuit (3);
the power supply circuit (3) comprising:
- a first DC voltage source (311) generating a first power supply potential;
- a first diode (313) connected in series between the first DC voltage source and said power supply node, and connected so that a forward current flows through it from the first voltage source to said power supply node;
- a second DC voltage source (323) generating a second power supply potential greater than the first power supply potential;
- a first resistor (322) connected in series between the second DC voltage source and said power supply node (33);
- a voltage-clipping circuit (4) comprising:
- a third DC voltage source (41);
- a second resistor (42) and a second diode (43) which are connected in series between the third DC voltage source and said power supply node, the second diode being connected so that a forward current flows through it from the third voltage source to said power supply node;
- a measurement terminal (45), connected to an intermediate node between the second resistor and the second diode.

2. Characterization device (1) according to Claim 1, wherein said voltage-clipping circuit (4) comprises:
- a third resistor (421) and a third diode (431) which is connected in series between the third DC voltage source (41) and said power supply node (33);
- an additional measurement terminal (451), connected to an intermediate node between the third resistor and the third diode.

3. Characterization device (1) according to Claim 1 or 2, wherein said voltage-clipping circuit (4) comprises fourth and fifth diodes (47, 48), said fourth and fifth diodes and said second resistor (42) being connected in parallel, the anode of the fourth diode being connected to the cathode of the fifth diode.

4. Characterization device (1) according to any one of the preceding claims, furthermore comprising an RLC circuit (331, 332, 333, 334) connected between said first resistor (322) and said power supply node (33).

5. Characterization device (1) according to any one of the preceding claims, comprising a decoupling capacitor (314) connected in parallel with said first DC voltage source (311).

6. Characterization device (1) according to any one of the preceding claims, comprising a decoupling capacitor (321) connected in parallel with said second DC voltage source (323).

7. Characterization device (1) according to any one of the preceding claims, wherein said first diode (313) has a breakdown voltage equal to at least 100 V, a DC forward current equal to at least 1 A and a forward recovery time equal to at most 1 µs.

8. Characterization device (1) according to any one of the preceding claims, wherein the first DC voltage source (311) is configured to deliver a current equal to at least 1 A.

9. Characterization device (1) according to Claim 8, wherein the first DC voltage source (311) is configured to generate a first power supply potential equal to at most 20 V.

10. Characterization device (1) according to any one of the preceding claims, wherein the second DC voltage source (323) is configured to generate a power supply potential equal to at least 100 V.

11. System comprising:
- a characterization device (1) according to any one of the preceding claims;
- a power switch (2) having a control electrode, a first conduction electrode (22) connected to the power supply node (33), and a second conduction electrode (21) with respect to the potential of which said power supply potentials of the first to third DC power sources are generated;
- a control circuit (24) configured to sequentially apply an opening signal and a closing signal to the control electrode (23) of the power switch.

12. System according to Claim 11, furthermore comprising an acquisition device (5) connected to said measurement terminal.

13. System according to Claim 12, wherein the acquisition device (5) comprises a conversion circuit for converting the voltage applied to the measurement terminal (45) into a value of the voltage present on the first conduction electrode (22) of said power switch, the conversion circuit being configured to measure a first voltage on the measurement terminal when the power switch is stabilized in the closed state, and configured to measure a second voltage on the measurement terminal when the power switch is open and the second DC voltage source applies a predetermined voltage, the conversion circuit being furthermore configured to extrapolate an affine conversion law depending on the first and second measured voltages and depending on said predetermined voltage.
